# EUROPEAN PATENT APPLICATION

(11) **EP 4 439 640 A1**
(43) Date of publication of application: **02.10.2024**
(21) Application number: 23209587.7
(22) Date of filing: 14.11.2023
(51) Int. Cl.: H01L 21/768, H01L 23/522

(54) **BACK SIDE INTERCONNECT PATTERNING AND FRONT SIDE METAL INTERCONNECT ON A TRANSISTOR LAYER**

(30) Priority: 27.03.2023 US 202318126702
(71) Applicant: Intel Corporation, Santa Clara, CA 95054 (US)
(72) Inventor: MANNEBACH, Ehren, Tigard, 97223 (US); MILLS, Shaun, Hillsboro, 97123 (US); D'SILVA, Joseph, Hillsboro, 97124 (US); KOBRINSKY, Mauro J., Portland, 97229 (US)
(74) Representative: Maiwald GmbH

(57) **Abstract**

Embodiments described herein may be related to apparatuses, processes, systems, and/or techniques for forming a package that has a transistor layer with a front side metal interconnect layer and a back side metal contact and interconnect layer. In particular, back side metal contact and interconnect layers may be patterned before a transistor layer, or other device layer, is formed on the patterned layers and before front side metal interconnect layers are formed on the transistor layer. Other embodiments may be described and/or claimed.

## Description

### FIELD

Embodiments of the present disclosure generally relate to the field of semiconductor manufacturing, and in particular to transistor layers with front side metal interconnect layers and back side metal interconnect layers.

### BACKGROUND

Continued growth in virtual machines, cloud computing, and portable devices will continue to increase the demand for high density layers of transistors within chips and packages. In addition, there will be an increased need for high quality interconnects to both sides of the layers of transistors for both power and signal.

### BRIEF DESCRIPTION OF THE DRAWINGS

FIG. 1 shows diagrams that include an isometric view, a fin cut view, and a gate cut view of a package that has a transistor layer with a front side metal interconnect layer and a back side metal interconnect layer, in accordance with various embodiments.
FIGs. 2A-2J show gate cuts and fin cuts of various stages in a manufacturing process for creating a package that has a transistor layer with a front side metal interconnect layer and a back side metal interconnect layer, in accordance with various embodiments.
FIG. 3 illustrates an example process for manufacturing a package that has a transistor layer with a front side metal interconnect layer and a back side metal interconnect layer, in accordance with various embodiments.
FIG. 4 illustrates a computing device in accordance with one implementation of the invention.
FIG. 5 illustrates an interposer that includes one or more embodiments of the invention.

### DETAILED DESCRIPTION

Embodiments described herein may be related to apparatuses, processes, systems, and/or techniques for forming a package that has a transistor layer with a front side metal interconnect layer on one side of the transistor layer and a back side metal contact and/or metal interconnect layer on the opposite side of the transistor layer. In embodiments, the back side metal contact and interconnect layers may be patterned before a transistor layer is formed on the patterned layers and/or before front side metal interconnect layers are formed on the transistor layer.

After the transistor layer and the front side metal interconnect layers have been formed, the patterned back side metal contact and interconnect layers may then be metallized to form back side metal contact and interconnect layers. Subsequent back side metal layers may then be formed on the package. In embodiments, the transistor layer may include one or more layers. In embodiments, the transistor layer may include any devices such as logic devices, memory devices, or other such devices that may use front side and back side interconnects. It should also be appreciated that the techniques described herein to create the back side metal contact and interconnect layers may be used to create only back side metal contacts. For simplicity, the back side metal contact and interconnect layers will be referred to herein as back side metal interconnect layers.

In embodiments, the back side metal interconnect layers may electrically couple with the transistors in the transistor layer to provide various voltages to back side contacts of various transistor components of the transistor layer. For example, electrical routings in a back side metal layer 0 (BM0) may electrically couple with back side gate contacts (BVG) or back side trench contacts (BVT). In embodiments, a separate via layer may be between the BM0 and transistor gates or transistor sources/drains. In particular, techniques described herein may be used to achieve tight-pitch interconnects for these back side contacts, for example, pitches that are less than 100 nm.

In legacy implementations, tight-pitch interconnects may be difficult to achieve during back side processing of a wafer, and large-pitch back side interconnects do not scale as the number of transistors within a transistor layer increases without enlarging the footprint of the package. Furthermore, legacy techniques of achieving tight registration are made difficult by high order, in-plane wafer distortion introduced during the device wafer flipping and bonding process. These legacy implementations were employed in order to move power connections directly underneath one or more transistors in a transistor layer within a package.

In embodiments using techniques described herein, tight-pitch connections that are a part of back metal side layers, such as BM0 and/or BVG or BVT connections, may be patterned on a wafer before the creation of the transistor layer and the front side metal interconnect layers on the transistor layer. As a result, this technique enables tight registration of metal contacts to the various transistor components.

In embodiments, the patterning of the back side contacts and back side metal layers may use a placeholder material, or sacrificial material, such as titanium nitride (TiN), tungsten (W), molybdenum, ruthenium, or a dielectric material that may be subsequently removed and filled with an electrically conductive metal such as copper (Cu), cobalt (Co), and/or tungsten (W). Note that the patterning process may result in a taper, or a V-shape, in the sides of vias created in the pattern material with a wider opening of the via at the top of the pattern material that is exposed to the patterning process. In embodiments, the patterning process may include etching into a dielectric. Subsequently, a device silicon layer, or other transistor channel material like silicon germanium (SiGe), germanium (Ge), a III-V material, a 2D material, or a transition-metal dichalcogenide (TMD), or the like, may be layer-transferred on top of the patterned back side layers.

Formation of the transistor layer may continue on the pattern material, followed by front side processing on the transistor layer, using known techniques, to form the front side metal interconnects. When front side processing is completed, the wafer may then be bonded to a carrier, flipped, revealing the patterned back side layers. The sacrificial material may then be removed and replaced with a suitable contact/interconnect material, for example, copper, cobalt, and/or tungsten, or some other electrically conductive material or metal. In embodiments, after the wafer is flipped, even if the back side layer patterns get somewhat distorted, this distortion may have a minimal effect upon the quality of the resulting back side metal connections. In embodiments, these techniques may be combined with other legacy back side power contact formation techniques.

Embodiments and/or techniques described herein may apply to transistor devices of any shape, for example, planar, fin, nanowire, nanoribbon, nanocomb/forksheet, and the like. In embodiments, a number of different materials for the transistor devices may be used, such as silicon (Si), silicon germanium (SiGe), germanium (Ge), III-V, a 2D material, a TMD, or the like. In embodiments, while a single layer of transistors is referenced, in other embodiments multiple layers of transistors may be used.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

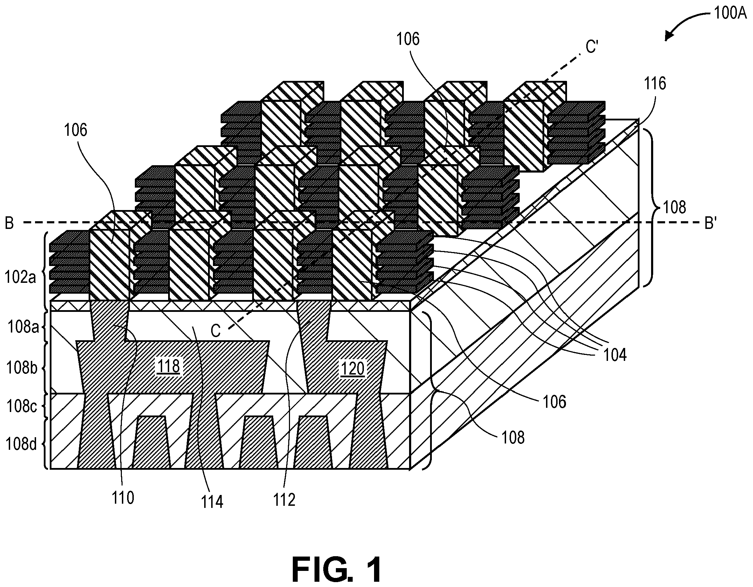

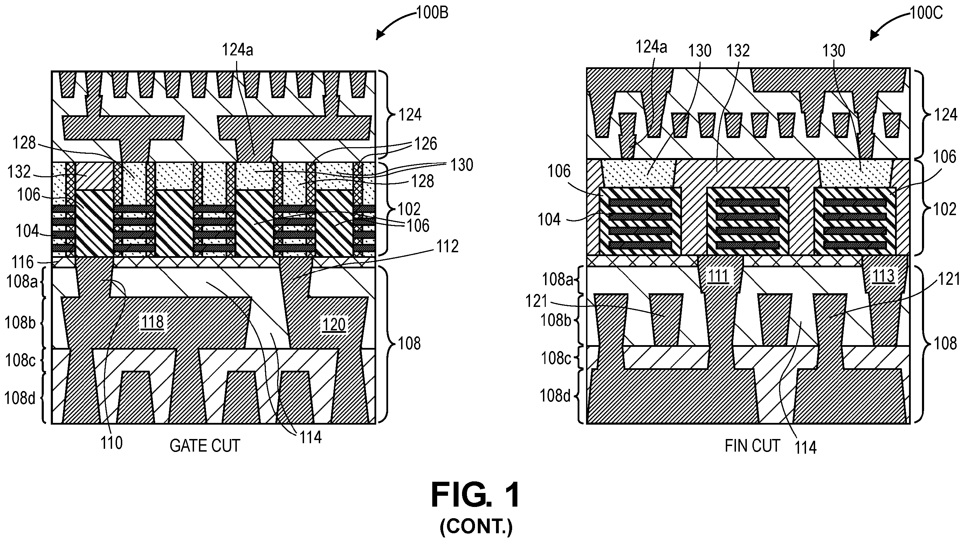

FIG. 1 shows an isometric view, a fin cut view, and a gate cut view of a package that has a transistor layer with a front side metal interconnect layer and a back side metal interconnect layer, in accordance with various embodiments. Note that FIG. 1 shows only one embodiment of a routing/interconnect design, without limiting the scope of other embodiments. Diagram 100A shows an isometric view of a portion of a package with a transistor layer 102a that includes a plurality of nanoribbons 104 and a plurality of gates 106. The transistor layer 102a may be on top of a plurality of back side metal layers 108, which may be referred to as back side metal interconnect layers, that may include a back side contact layer 108a, a back side metal zero layer 108b (BM0), a back side metal one layer 108c (BM1), and a back side metal two layer 108d (BM2). Note front side metal layers (not shown) above the transistor layer 102a are not shown for clarity of diagram 100A.

In embodiments, the back side contact layer 108a may include a first back side contact 110 that electrically couples with a bottom side of a gate 106, and a second back side contact 112 that may electrically couple with a metal contact (not shown) that surrounds a portion of the plurality of nanoribbons 104. The first back side contact 110 and the second back side contact 112 may be electrically isolated from each other by a surrounding dielectric 114 that is also in the back side contact layer 108a. In embodiments described herein, the back side contact layer 108a may be originally formed as a pattern in the surrounding dielectric 114 before the transistor layer 102a is manufactured on top of the back side contact layer 108a. In embodiments, there may be a bonding layer 116 below the transistor layer 102a and above the back side contact layer 108a to facilitate adhesion with the back side metal layers 108. In particular, the bonding layer 116 may be used when layer transfer techniques are used to build the transistor layer 102a on the back side contact layer 108a.

In embodiments, the BM0 layer 108b may include first metal 118 that is electrically coupled with the first back side contact 110, and second metal 120 that is electrically coupled with the second back side contact 112. Other metal structures 121 (shown in diagram 100C) may be within the BM0 layer 108b. Note that various other metal vias and/or metal routings metals that appear in the BM1 layer 108c and BM2 layer 108d may electrically couple with the first metal 118 and the second metal 120. Note that in embodiments described further below, the BM1 layer 108c and BM2 layer 108d may be formed after the transistor layer 102a has been formed.

Diagram 100B shows a fin cut of a package that may be similar to the package of diagram 100A, where the fin cut is along B-B' of diagram 100A perpendicular to the transistor layer 102a. Transistor layer 102, which may be similar to transistor layer 102a of diagram 100A, is on top of the back side metal layers 108, with front side metal layers 124, which may be referred to as front side metal interconnect layers, on top of the transistor layer 102. The transistor layer 102 may include gates 106 with nanoribbons 104 extending through the gates 106. In embodiments, gate spacers 126 may be on either side of gates 106. In embodiments, contacts 128 may be between the gate spacers 126 and may electrically couple with the front side metal layers 124. The contacts 128 may also electrically couple with the second back side contact 112 within the back side contact layer 108a. In embodiments, the second back side contact 112 may be referred to as BVT.

In embodiments, gate contacts 130 may be on top of a gate 106 and may electrically couple with the front side metal layers 124 through front side metal layer contact 124a. In some embodiments, a dielectric 132 may be on top of the gate 106 that may provide electrical isolation between the gate 106 and the front side metal layers 124. The first back side contact 110, which may be referred to as a BVG, may electrically couple with the gate 106. Note that in embodiments, a bonding layer 116 may be between the back side metal layers 108 and the transistor layer 102.

Diagram 100C shows a gate cut of a package that may be similar to the package shown in diagram 100A, where the gate cut is along C-C' of diagram 100A perpendicular to the transistor layer 102a. The back side contact layer 108a may include a third back side contact 111 and a fourth back side contact 113 that may electrically couple the BM0 layer 108b with the gates 106. Note that a dielectric 132 may surround a portion of the gates 106, and gate contacts 130 may electrically couple some of the gates 106 with the front side metal layers 124.

Turning back to diagram 100B, and as discussed further herein, it should be noted that the taper of the metal features of the first metal 118, the second metal 120, the first back side contact 110, and the second back side contact 112 have a same taper. This taper may be opposite of the taper shown in the metal features within BM1 layer 108c and BM2 108d, due to the shape of the metal features of BM1 layer 108c and BM2 108d being formed after the formation of the transistor layer 102 and the front side metal layers 124. For example, the first backside contact 110, the second back side contact 112 of the back side contact layer 108a, and the front side metal layer contact 124a taper away from the transistor layer 102, where the metal features in the BM1 layer 108c taper toward the transistor layer 102. Analogous taper differences are shown in diagram 100C. This may be due to different etching directions due to flipping during fabrication, described further below.

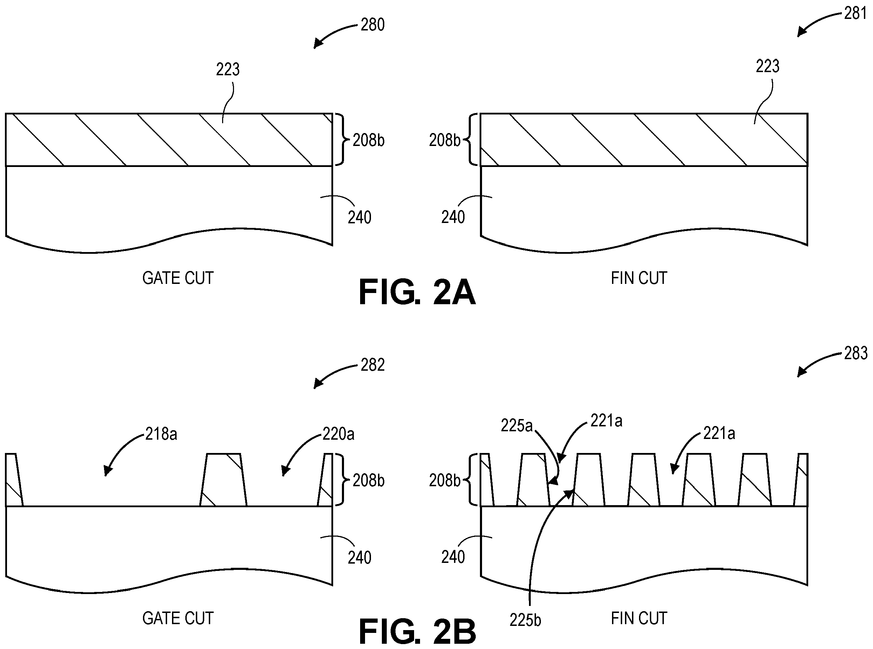

FIGs. 2A-2F show gate cuts and fin cuts of various stages in a manufacturing process for creating a package that has a transistor layer with a front side metal interconnect layer and a back side metal interconnect layer, in accordance with various embodiments. FIG. 2A shows a stage in the manufacturing process that includes diagrams 280, 281, which show a gate cut and a fin cut, respectively, which may be similar to diagrams 100B, 100C of FIG. 1. In embodiments, a wafer 240 may be provided and a layer 208b, which may be similar to BM0 layer 108b of FIG. 1, may be formed on top of the wafer 240. In embodiments, a dielectric 223, which may include an interlayer dielectric (ILD), is placed on the wafer 240 within the layer 208b.

FIG. 2B shows a stage in the manufacturing process that includes diagrams 282, 283, which show a gate cut and a fin cut, respectively, which may be similar to diagrams 100B, 100C of FIG. 1. In embodiments, layer 208b has been patterned, forming holes 218a, 220a, and 221a, through the dielectric 223 that may extend to the wafer 240. In embodiments, an etching technique, or some other known process, may be used. Note that each of the holes 218a, 220a, and 221a have a taper that is a result of the etching technique. Note also that the taper shown in the figures herein may be exaggerated for clarity of description. For example, sides 225a, 225b are not perpendicular to a plane of the wafer 240, but are sloped due to the etching process.

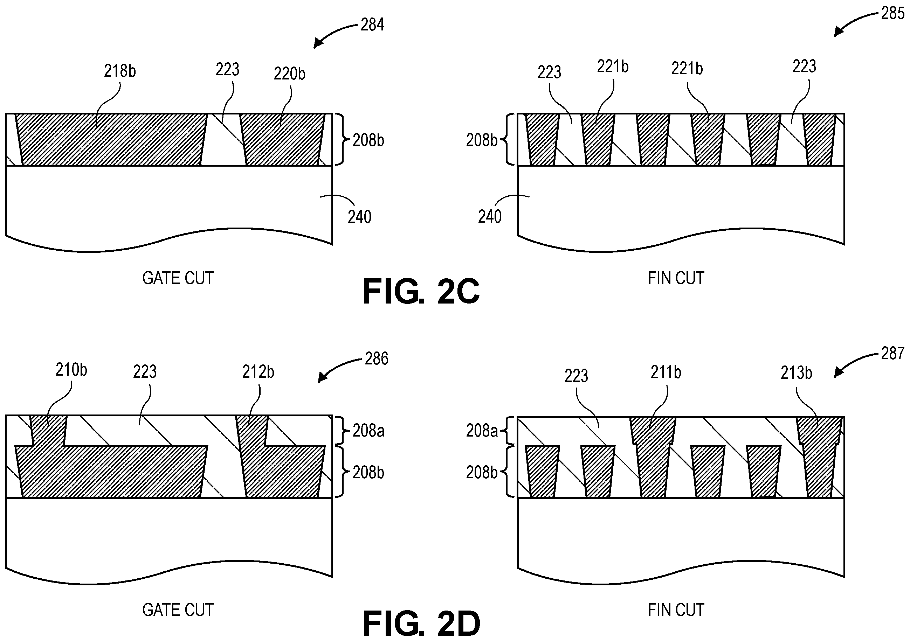

FIG. 2C shows a stage in the manufacturing process that includes diagrams 284, 285, which show a gate cut and a fin cut, respectively, which may be similar to diagrams 100B, 100C of FIG. 1. In embodiments, the holes 218a, 220a, 221a of FIG. 2B have been filled with a sacrificial placeholder material 218b, 220b, 221b. In embodiments, the sacrificial material may include titanium nitride, tungsten, molybdenum, a dielectric, or any other suitable material that can be removed with selectivity to the dielectric 223. A planarization process may then be performed.

FIG. 2D shows a stage in the manufacturing process that includes diagrams 286, 287, which show a gate cut and a fin cut, respectively, which may be similar to diagrams 100B, 100C of FIG. 1. A patterned back side contact layer 208a, which may be similar to back side contact layer 108a of FIG. 1, may then be placed on layer 208b, using techniques similar to those described above. As a result, sacrificial placeholder material 210b, 211b, 212b, 213b are formed within the dielectric 223 of patterned back side contact layer 208a. A planarization process may then be performed.

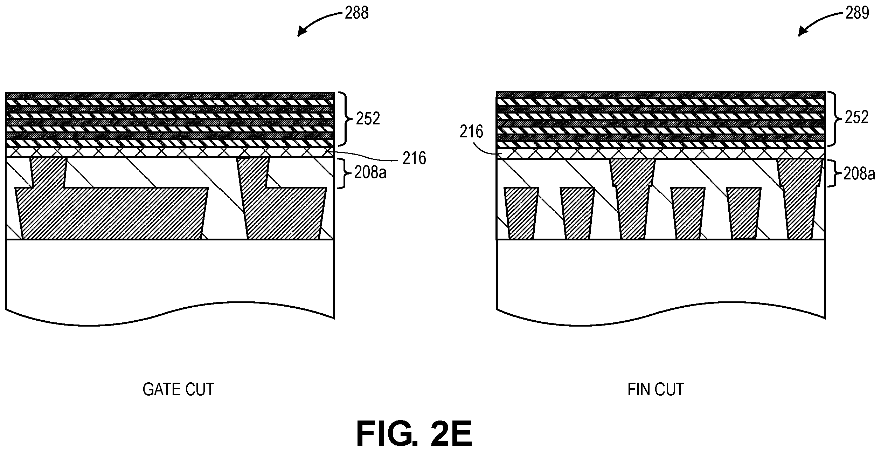

FIG. 2E shows a stage in the manufacturing process that includes diagrams 288, 289, which show a gate cut and a fin cut, respectively, which may be similar to diagrams 100B, 100C of FIG. 1. In embodiments, a bonding layer 216, which may be similar to bonding layer 116 of FIG. 1, may be placed on the patterned back side contact layer 208a. In embodiments, the bonding layer 116 may include silicon, oxygen, nitrogen, SiO, SiN, SiON, and/or the like.

In embodiments, a semiconductor device stack 252 may be layer transferred onto the bonding layer 216. In embodiments, the semiconductor device stack 252 may include a silicon/silicon germanium super-lattice for the embodiments that include gate-all-around transistors as shown in FIG. 2E.

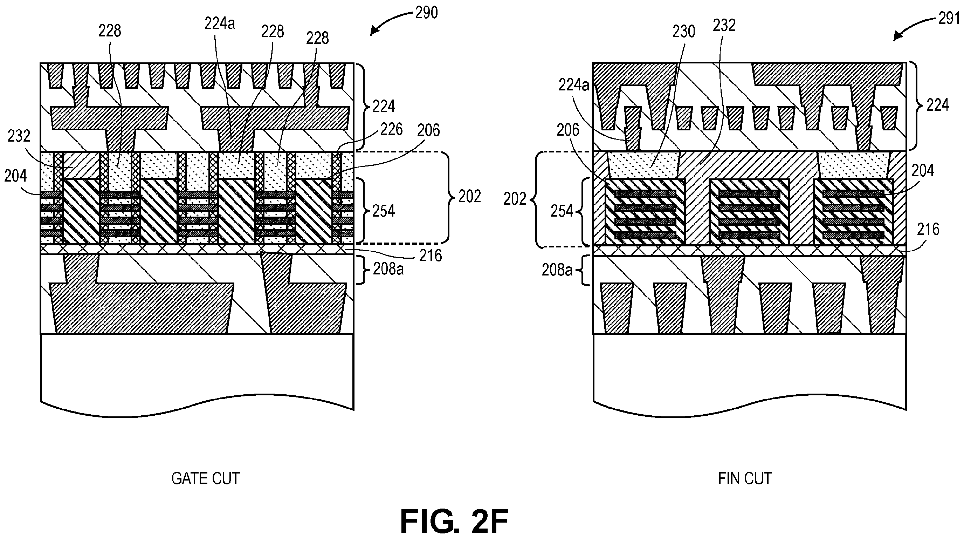

FIG. 2F shows a stage in the manufacturing process that includes diagrams 290, 291, which show a gate cut and a fin cut, respectively, which may be similar to diagrams 100B, 100C of FIG. 1. In embodiments, various transistors 254 within transistor layer 202 have been fabricated and aligned, as appropriate, with the patterned back side contact layer 208a. In embodiments, the transistor layer 202 may include various nanoribbons 204, gates 206 with spacers 226, and contacts 228, which may be similar to nanoribbons 104, gates 106, gate spacers 126, and contacts 128 of FIG. 1. In embodiments, gate contacts 230, which may be similar to gate contacts 130 of FIG. 1, may be formed on the gates 206. A dielectric 232, which may be similar to dielectric 132 of FIG. 1, may also be placed to create transistor layer 202, which may be similar to transistor layer 102 of FIG. 1.

In embodiments, after creation of the transistor layer 202, front side metal layers 224, which may be similar to front side interconnect metal layers 124 of FIG. 1, may then be formed on top of the transistor layer 202 using legacy techniques. In embodiments, front side metal layer contact 224a, which may be similar to front side metal layer contact 124a of FIG. 1, may electrically couple with the gate contact 230.

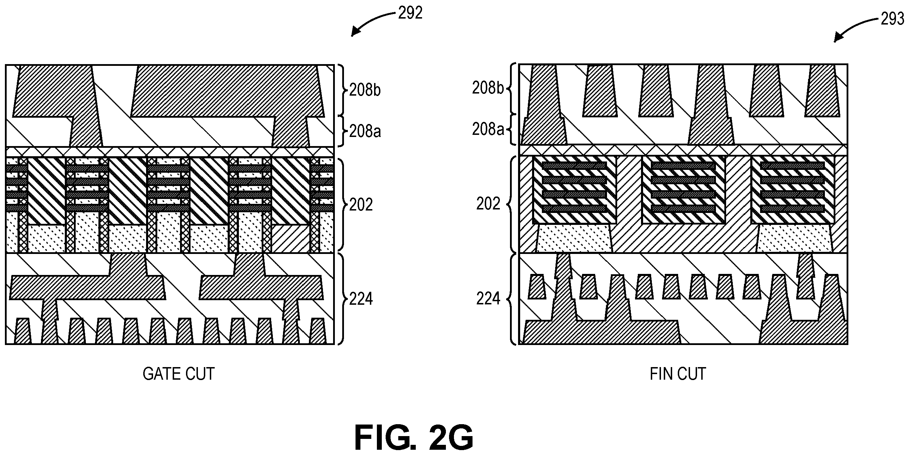

FIG. 2G shows a stage in the manufacturing process that includes diagrams 292, 293, which show a gate cut and a fin cut, respectively, which may be similar to diagrams 100B, 100C of FIG. 1. In embodiments, a flipping procedure occurs and the wafer 240 of FIG. 2A is removed. Note that in embodiments, carrier wafer (not shown) may be used during the flipping procedure. Note that in embodiments, any misalignment and/or distortions that may occur during the flipping procedure will not affect the alignment of the patterned back side contact layer 208a with the transistor layer 202.

In embodiments, a planarization process of layer 208b may be performed. As a result, in embodiments, layer 208b is on patterned back side contact layer 208a, patterned back side contact layer 208a is on transistor layer 202, and transistor layer 202 is on front side metal layers 224.

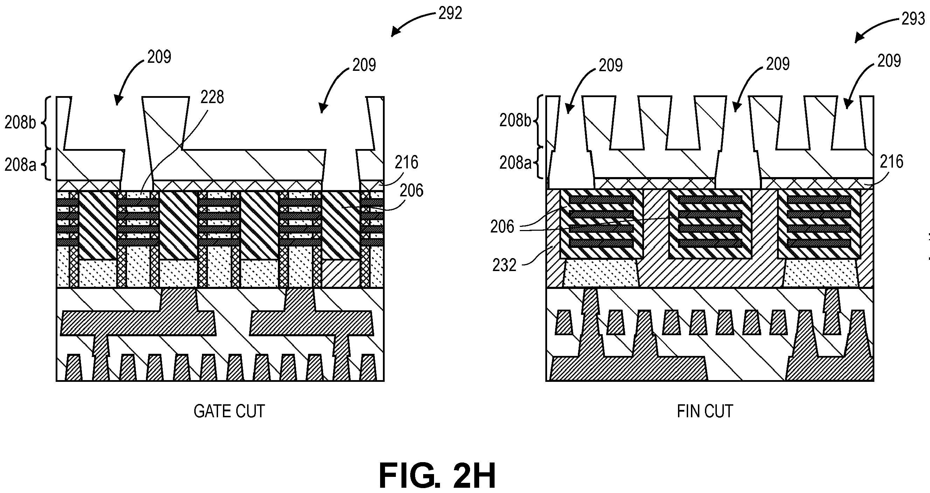

FIG. 2H shows a stage in the manufacturing process that includes diagrams 292, 293, which show a gate cut and a fin cut, respectively, which may be similar to diagrams 100B, 100C of FIG. 1. Voids 209 may be created by applying a selective removal of sacrificial placeholder material 211b, 212b, 218b, 220b, 221b, of FIGs. 2C-2D. In embodiments, the selective removal may be performed using an isotropic dry etch, for example a vapor phased etch, or a wet etch. Note that in embodiments, the voids 209 may extend through the bonding layer 216 and expose a portion of the gate 206, or expose a portion of the contacts 228.

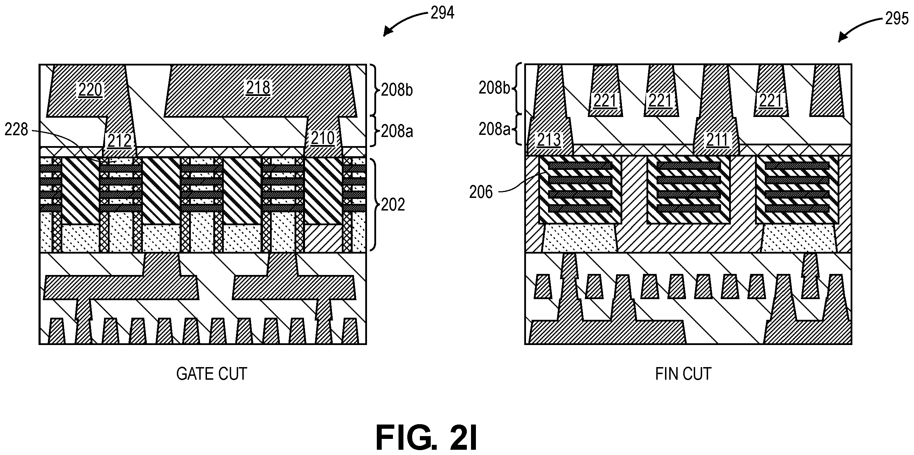

FIG. 2I shows a stage in the manufacturing process that includes diagrams 294, 295, which show a gate cut and a fin cut, respectively, which may be similar to diagrams 100B, 100C of FIG. 1. In embodiments, a metallization process occurs to fill the voids 209 from FIG. 2H. As a result, contacts 210, 211, 212, 213 may be formed, which may be similar to first back side contact 110, second back side contact 112, third back side contact 111, and fourth back side contact 113 of FIG. 1. Similarly, first metal 218, second metal 220, and other metal structures 221 may be formed, which may be similar to first metal 118, second metal 120, and other metal structures 121 of FIG. 1. The back side contacts 210, 211, 212, 213 may come into electrical contact with a gate 206, or a contact 228 within the transistor layer 202.

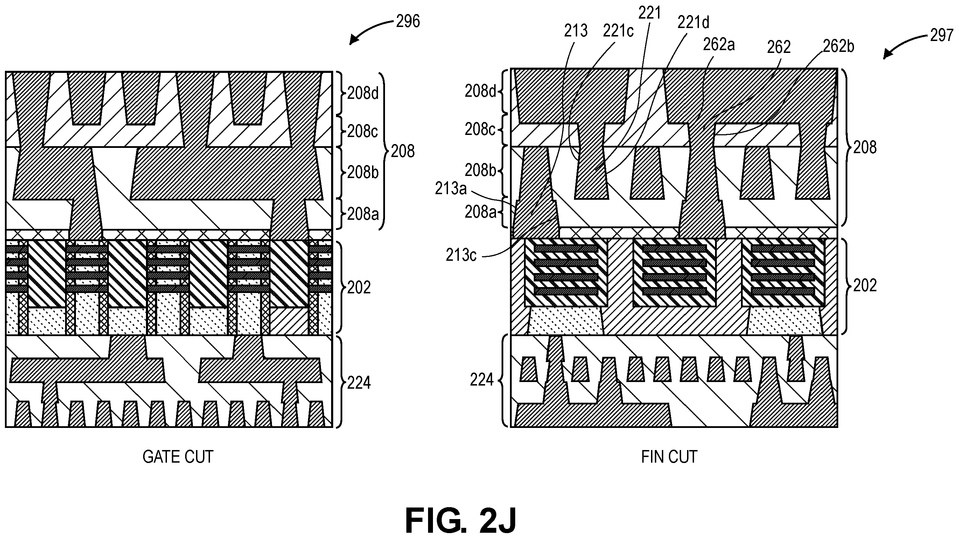

FIG. 2J shows a stage in the manufacturing process that includes diagrams 296, 297, which show a gate cut and a fin cut, respectively, which may be similar to diagrams 100B, 100C of FIG. 1. In embodiments, layer 208c may be formed on layer 208b, and layer 208d may be formed on layer 208c, and may be electrically coupled with the transistor layer 202. In embodiments, the layers 208c, 208d may be formed using legacy techniques.

It should be noted that the taper of contacts within layers 208a, 208b, for example a taper of contact 213 with sides 213a, 213c, and a taper of contact 221 with sides 221c, 221d, are different tapers in an opposite direction, than a taper of a contact 262 within layer 208c with sides 262a and 262b. This is because the patterning for layers 208a, 208b were done prior to the formation of a transistor layer 202, and the patterning for layers 208c, 208d were done after the formation of the transistor layer 202. It should also be noted that the taper of a contact 224a within the front side metal layers 224 may have the same taper as the contacts in layers 208a, 208b. In embodiments, the slope of the sides 221c, 221d of contact 221 may be at an angle that is less than 90° with respect to a plane of the transistor layer 202.

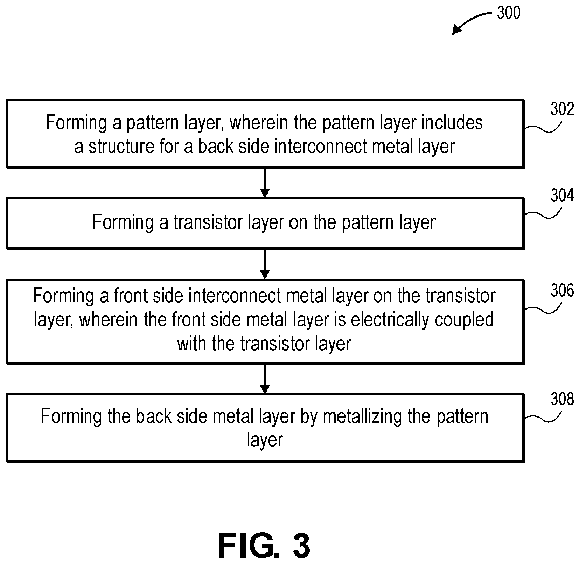

FIG. 3 illustrates an example process for manufacturing a package that has a transistor layer with a front side metal interconnect layer and a back side metal interconnect layer, in accordance with various embodiments. In embodiments, process 300 may be performed using the techniques, processes, apparatus, and/or systems described herein, and in particular with respect to FIGs. 1-2J.

At block 302, the process may include forming a pattern layer, wherein the pattern layer includes a structure for a back side interconnect metal layer. In embodiments, the pattern layer may be similar to pattern back side contact layer 208a and layer 208b of FIG. 2D.

At block 304, the process may further include forming a transistor layer on the pattern layer. In embodiments, the transistor layer may be similar to transistor layer 102 of FIG. 1, or transistor layer 202 of FIG. 2J.

At block 306, the process may further include forming a front side interconnect metal layer on the transistor layer, wherein the front side metal layer is electrically coupled with the transistor layer. In embodiments, the front side metal layer may be similar to front side metal layers 124 of FIG. 1, or front side metal layers 224 of FIG. 2J.

At block 308, the process may further include forming the back side metal layer by metallizing the pattern layer. In embodiments, the back side metal layer may be similar to layers 108a, 108b, 108c, 108d of FIG. 1, back side metal layers 108 of FIG. 1, layers 208a, 208b, 208c, 208d of FIG. 2J, or back side metal layers 208 of FIG. 2J.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

In embodiments, a substrate, which may be referred to as a package substrate, or an interposer may be used to route power and/or I/O between a die and other external components, for example, a motherboard and/or a power source.

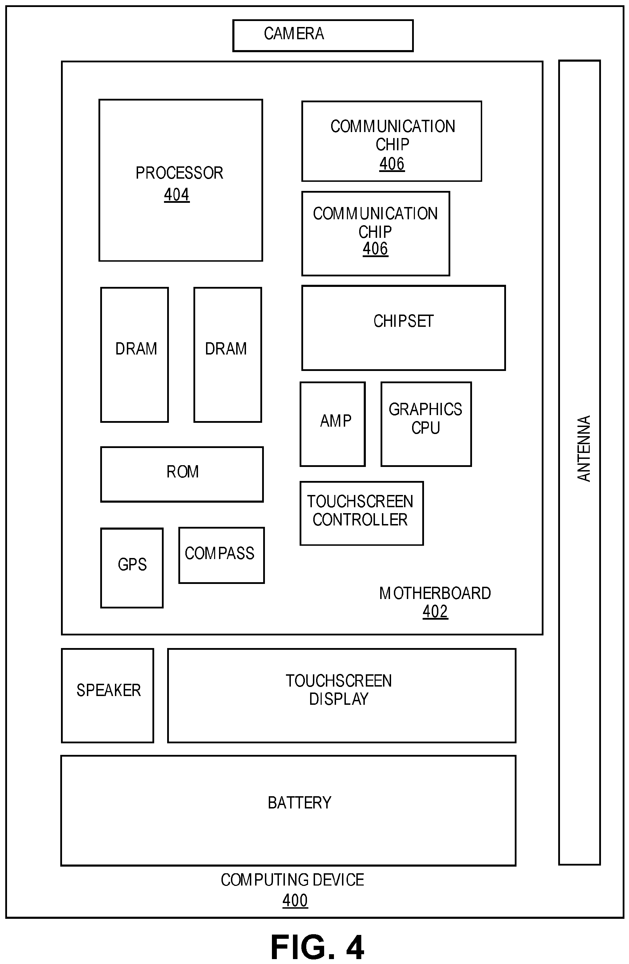

FIG. 4 illustrates a computing device 400 in accordance with one implementation of the invention. The computing device 400 houses a board 402. The board 402 may include a number of components, including but not limited to a processor 404 and at least one communication chip 406. The processor 404 is physically and electrically coupled to the board 402. In some implementations the at least one communication chip 406 is also physically and electrically coupled to the board 402. In further implementations, the communication chip 406 is part of the processor 404.

Depending on its applications, computing device 400 may include other components that may or may not be physically and electrically coupled to the board 402. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 406 enables wireless communications for the transfer of data to and from the computing device 400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 406 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 400 may include a plurality of communication chips 406. For instance, a first communication chip 406 may be dedicated to shorter range wireless communications such as Wi-Fi and Bluetooth and a second communication chip 406 may be dedicated to longer range wireless communications such as GPS, EDGE, GPRS, CDMA, WiMAX, LTE, Ev-DO, and others.

The processor 404 of the computing device 400 includes an integrated circuit die packaged within the processor 404. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 406 also includes an integrated circuit die packaged within the communication chip 406. In accordance with another implementation of the invention, the integrated circuit die of the communication chip includes one or more devices, such as MOS-FET transistors built in accordance with implementations of the invention.

In further implementations, another component housed within the computing device 400 may contain an integrated circuit die that includes one or more devices, such as MOS-FET transistors built in accordance with implementations of the invention.

In various implementations, the computing device 400 may be a laptop, a netbook, a notebook, an ultrabook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, or a digital video recorder. In further implementations, the computing device 400 may be any other electronic device that processes data.

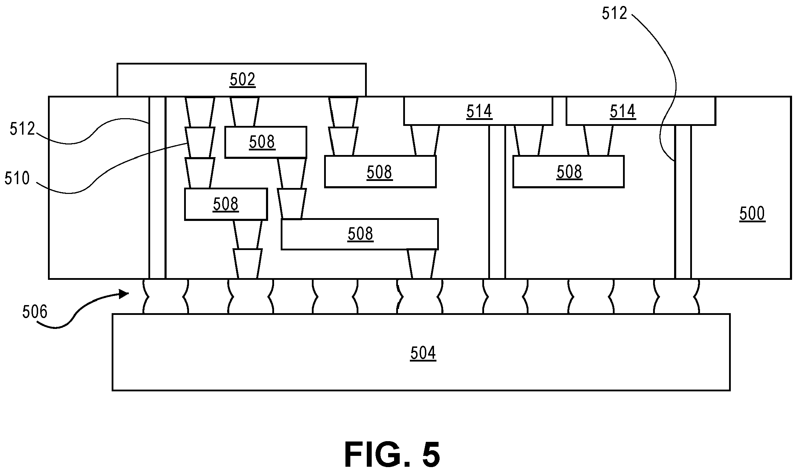

FIG. 5 illustrates an interposer 500 that includes one or more embodiments of the invention. The interposer 500 is an intervening substrate used to bridge a first substrate 502 to a second substrate 504. The first substrate 502 may be, for instance, an integrated circuit die. The second substrate 504 may be, for instance, a memory module, a computer motherboard, or another integrated circuit die. Generally, the purpose of an interposer 500 is to spread a connection to a wider pitch or to reroute a connection to a different connection. For example, an interposer 500 may couple an integrated circuit die to a ball grid array (BGA) 506 that can subsequently be coupled to the second substrate 504. In some embodiments, the first and second substrates 502/504 are attached to opposing sides of the interposer 500. In other embodiments, the first and second substrates 502/504 are attached to the same side of the interposer 500. And in further embodiments, three or more substrates are interconnected by way of the interposer 500.

The interposer 500 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials.

The interposer may include metal interconnects 508 and vias 510, including but not limited to through-silicon vias (TSVs) 512. The interposer 500 may further include embedded devices 514, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 500. In accordance with embodiments of the invention, apparatuses or processes disclosed herein may be used in the fabrication of interposer 500.

Although certain embodiments have been illustrated and described herein for purposes of description, a wide variety of alternate and/or equivalent embodiments or implementations calculated to achieve the same purposes may be substituted for the embodiments shown and described without departing from the scope of the present disclosure. This application is intended to cover any adaptations or variations of the embodiments discussed herein. Therefore, it is manifestly intended that embodiments described herein be limited only by the claims.

Where the disclosure recites "a" or "a first" element or the equivalent thereof, such disclosure includes one or more such elements, neither requiring nor excluding two or more such elements. Further, ordinal indicators (e.g., first, second or third) for identified elements are used to distinguish between the elements, and do not indicate or imply a required or limited number of such elements, nor do they indicate a particular position or order of such elements unless otherwise specifically stated.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments.

### EXAMPLES

Example 1 is an apparatus comprising: a first layer that includes a plurality of transistors; a second layer above the first layer, the second layer includes a first plurality of contacts that are electrically coupled with a first set of the plurality of transistors; a third layer below the first layer, the third layer includes a second plurality of contacts that are electrically coupled with a second set of the plurality of transistors; and wherein at least one of the first plurality of contacts in the second layer tapers away from the first layer, and wherein at least one of the second plurality of contacts in the third layer tapers away from the first layer.

Example 2 includes the apparatus of example 1, further comprising: a fourth layer below the third layer, the fourth layer includes a third plurality of contacts that are electrically coupled with at least some of the second plurality of contacts; and wherein at least one of the third plurality of contacts tapers toward the first layer.

Example 3 includes the apparatus of examples 1 or 2, further comprising a bonding layer between the first layer and the third layer, wherein the at least one of the second plurality of contacts extends through the bonding layer.

Example 4 includes the apparatus of examples 1, 2, or 3, wherein the first plurality of contacts are directly electrically coupled with the first set of the plurality of transistors, and wherein the second plurality of contacts are directly electrically coupled with the second set of the plurality of transistors.

Example 5 includes the apparatus of examples 1, 2, 3, or 4, wherein the second layer is a part of front side interconnect metal layer structure, and wherein the third layer is a part of a back side interconnect metal layer structure.

Example 6 includes the apparatus of examples 1, 2, 3, 4, or 5, wherein the at least one of the first plurality of contacts includes a first metal via, and wherein the at least one of the second plurality of contacts includes a second metal via.

Example 7 includes the apparatus of examples 1, 2, 3, 4, 5, 6, wherein the first plurality of contacts or the second plurality of contacts include a selected one or more of copper, cobalt, molybdenum, ruthenium, or tungsten.

Example 8 includes the apparatus of examples 1, 2, 3, 4, 5, 6, or 7, wherein the first set of the plurality of transistors and the second set of the plurality of transistors are different sets.

Example 9 is a package assembly comprising: a package substrate; and an integrated circuit die coupled with the package substrate, the integrated circuit die including: a first layer that includes a plurality of transistors; a second layer above the first layer, the second layer includes a first plurality of metal contacts that are electrically coupled with a first set of the plurality of transistors; a third layer below the first layer, the third layer includes a second plurality of metal contacts that are electrically coupled with a second set of the plurality of transistors; and wherein a slope of a side of one of the first plurality of metal contacts is at a first angle with respect to a plane of the first layer, wherein the first angle is less than 90°, and wherein a slope of a side of one of the second plurality of metal contacts is at a second angle with respect to the plane of the first layer, wherein the second angle is less than 90°.

Example 10 includes the system of example 9, further comprising a bonding layer between the first layer and the third layer, wherein the at least one of the second plurality of contacts extends through the bonding layer.

Example 11 includes the system of examples 9 or 10, wherein the first plurality of contacts are directly electrically coupled with the first set of the plurality of transistors, and wherein the second plurality of contacts are directly electrically coupled with the second set of the plurality of transistors.

Example 12 includes the system of examples 9, 10, or 11, wherein the second layer is a part of front side interconnect metal layer structure, and wherein the third layer is a part of a back side interconnect metal layer structure.

Example 13 includes the system of examples 9, 10, 11, or 12, wherein the at least one of the first plurality of contacts includes a first metal via, and wherein the at least one of the second plurality of contacts includes a second metal via.

Example 14 includes the system of examples 9, 10, 11, 12, or 13, further comprising: wherein the plurality of transistors include a selected one or more of a FinFET, ribbon FET, fork FET, or planar transistors; and wherein a material of the transistor includes a selected one or more of silicon, germanium, a III-V material, a 2D material, or a transition-metal dichalcogenide (TMD).

Example 15 includes the system of examples 9, 10, 11, 12, 13, or 14, wherein the first plurality of contacts or the second plurality of contacts include a selected one or more of: copper, cobalt, molybdenum, ruthenium, or tungsten.

Example 16 is a method comprising: forming a pattern layer, wherein the pattern layer includes a structure for a back side interconnect metal layer; forming a transistor layer on the pattern layer; forming a front side interconnect metal layer on the transistor layer, wherein the front side metal layer is electrically coupled with the transistor layer; and forming the back side metal layer by metallizing the pattern layer.

Example 17 includes the method of example 16, further comprising before the step of forming the transistor layer: applying a bonding layer to the pattern layer; and wherein forming the transistor layer on the pattern layer further includes forming the transistor layer on the bonding layer.

Example 18 includes the method of example 17, wherein forming the transistor layer on the pattern layer further includes performing a layer transfer process of a portion of the transistor layer on the bonding layer.

Example 19 includes the method of examples 16, 17, or 18, wherein the pattern layer includes a sacrificial material deposited within an interlayer dielectric; and further comprising replacing the sacrificial material with an electrically conductive material.

Example 20 includes the method of example 19, wherein the electrically conductive material includes a selected one or more of: copper, aluminum, or titanium.

## Claims

1. An apparatus comprising:
a first layer that includes a plurality of transistors;
a second layer above the first layer, the second layer includes a first plurality of contacts that are electrically coupled with a first set of the plurality of transistors;
a third layer below the first layer, the third layer includes a second plurality of contacts that are electrically coupled with a second set of the plurality of transistors; and
wherein at least one of the first plurality of contacts in the second layer tapers away from the first layer, and wherein at least one of the second plurality of contacts in the third layer tapers away from the first layer.

2. The apparatus of claim 1, further comprising:
a fourth layer below the third layer, the fourth layer includes a third plurality of contacts that are electrically coupled with at least some of the second plurality of contacts; and
wherein at least one of the third plurality of contacts tapers toward the first layer.

3. The apparatus of claim 1 or 2, further comprising a bonding layer between the first layer and the third layer, wherein the at least one of the second plurality of contacts extends through the bonding layer.

4. The apparatus of claim 1, 2 or 3, wherein the first plurality of contacts are directly electrically coupled with the first set of the plurality of transistors, and wherein the second plurality of contacts are directly electrically coupled with the second set of the plurality of transistors.

5. The apparatus of claim 1, 2, 3 or 4, wherein the second layer is a part of front side interconnect metal layer structure, and wherein the third layer is a part of a back side interconnect metal layer structure.

6. The apparatus of claim 1, 2, 3, 4 or 5, wherein the at least one of the first plurality of contacts includes a first metal via, and wherein the at least one of the second plurality of contacts includes a second metal via.

7. The apparatus of claim 1, 2, 3, 4, 5 or 6, wherein the first plurality of contacts or the second plurality of contacts include a selected one or more of: copper, cobalt, molybdenum, ruthenium, or tungsten.

8. The apparatus of claim 1, 2, 3, 4, 5, 6 or 7, wherein the first set of the plurality of transistors and the second set of the plurality of transistors are different sets.

9. A method comprising:
forming a pattern layer, wherein the pattern layer includes a structure for a back side interconnect metal layer;
forming a transistor layer on the pattern layer;
forming a front side interconnect metal layer on the transistor layer, wherein the front side metal layer is electrically coupled with the transistor layer; and
forming the back side metal layer by metallizing the pattern layer.

10. The method of claim 9, further comprising before the step of forming the transistor layer:
applying a bonding layer to the pattern layer; and
wherein forming the transistor layer on the pattern layer further includes forming the transistor layer on the bonding layer.

11. The method of claim 10, wherein forming the transistor layer on the pattern layer further includes performing a layer transfer process of a portion of the transistor layer on the bonding layer.

12. The method of claim 9, 10 or 11, wherein the pattern layer includes a sacrificial material deposited within an interlayer dielectric; and
further comprising replacing the sacrificial material with an electrically conductive material.

13. The method of claim 12, wherein the electrically conductive material includes a selected one or more of: copper, aluminum, or titanium.
